# EUROPEAN PATENT APPLICATION

(11) **EP 4 734 704 A1**
(43) Date of publication of application: **29.04.2026**
(21) Application number: 25210946.7
(22) Date of filing: 24.10.2025
(51) Int. Cl.: H10F 19/33, H10F 19/37, H10F 19/80

(54) **TRANSPARENT SOLAR CELL MODULE WITH EXCELLENT AESTHETICS AND MANUFACTURING METHOD THEREOF**

(30) Priority: 25.10.2024 KR 20240147134
(71) Applicant: MECAROENERGY CO. LTD., Chungcheongbuk-do 27915 (KR)
(72) Inventor: KIM, Joung Youn, 27918 Jeungpyeong-gun (KR); LEE, Gyu Hyun, 27480 Chungju-si (KR)
(74) Representative: Gille Hrabal Partnerschaftsgesellschaft mbB Patentanwälte

(57) **Abstract**

The present disclosure relates to a transparent solar cell module with excellent aesthetics and a manufacturing method thereof. The method of manufacturing the transparent solar cell module according to an embodiment of the present disclosure includes: a first stage of forming a thin film solar cell including a thin film solar cell layer patterned on a glass substrate; and a second stage in which an upper glass substrate is disposed on an upper surface of the thin film solar cell, wherein the first stage includes: forming a pattern mask on the other surface of a surface on which the thin film solar cell layer of the glass substrate is formed; and forming the thin film solar cell layer by processing by irradiating a laser on an upper portion where the pattern mask is formed.

## Description

### CROSS-REFERENCE TO RELATED APPLICATION

This application claims the benefit of and priority to Korean Patent Application No. 10-2024-0147134, filed on October 25, 2024, the entire disclosure(s) of which is hereby incorporated herein by reference in its entirety.

### BACKGROUND

### Field

The present disclosure relates to a transparent solar cell module with excellent aesthetics and a manufacturing method thereof, and more particularly, to a transparent solar cell module that allows light transmission and allows for the formation of design patterns and a manufacturing method thereof.

### Description of Related Art

Conventional technologies using silicon as the primary material have manufactured transparent (see-through) solar cells perforated by drilling holes into silicon wafers.

However, according to the conventional technologies, the small size of the silicon wafers limits implementation. Drilling holes is time-consuming and costly, and breakage may make implementation quite challenging.

In contrast, thin film solar cells are configured by depositing thin films on a glass substrate, and thus there is a relative advantage of forming designs through thin film processing. However, damage may occur during a pattern formation process, such as the thin films being laminated melting and connecting to each other.

Furthermore, in the case of existing pattern forming modules, the pattern forming technology was used by bonding the front glass on which the pattern was formed or by customizing the same in a puzzle shape so that a dead line existed in the module, which reduced visibility and energy conversion efficiency.

In addition, since a large amount of metal bonding was required during the process of connecting solar cells, the complex manufacturing process and the metal exposed in the transparent area resulted in poor visibility and aesthetics.

### Related art document

### Patent document

Korean Patent No. 10-2584910, October 6, 2023

### SUMMARY

The present disclosure has been devised to obviate the above limitation. An aspect of the present disclosure is directed to providing a transparent solar cell module with excellent aesthetics that minimizes dead lines that may occur during pattern formation, maximizes energy conversion efficiency by utilizing the solar cell layer as is, and allows appropriate light to pass through, and a manufacturing method thereof.

More specifically, an aspect of the present disclosure is designed to alleviate the output reduction caused by shading of products that provide aesthetics by adding patterns and designs to the front glass of solar cell modules in existing technologies, and to maximize energy conversion efficiency as well as visibility and aesthetics by enabling design through processing of the thin film itself.

A method of manufacturing a transparent solar cell module according to an embodiment of the present disclosure includes: a first stage of forming a thin film solar cell including a thin film solar cell layer patterned on a glass substrate; and a second stage in which an upper glass substrate is disposed on an upper surface of the thin film solar cell, wherein the first stage includes: forming a pattern mask on the other surface of a surface on which the thin film solar cell layer of the glass substrate is formed; and forming the thin film solar cell layer by processing by irradiating a laser on an upper portion where the pattern mask is formed.

According to another embodiment of the present disclosure, the formation of the thin film solar cell layer may be configured to form the thin film solar cell layer including an electrode (busbar) by irradiating a laser on the pattern mask formed on the other surface of the surface on which the thin film solar cell layer of the glass substrate is formed.

According to another embodiment of the present disclosure, the formation of the thin film solar cell layer may be configured to form the thin film solar cell layer with a processing line width of 0.05 mm to 5 mm by irradiating the pattern mask formed on the other surface of the surface on which the thin film solar cell layer of the glass substrate is formed with an overlap rate of laser beams of 50% or more.

According to another embodiment of the present disclosure, after the formation of the thin film solar cell layer, the method may further include forming a terminal made of copper or aluminum material connected to the electrode (busbar) by a conductive tape, ultrasonic welding, or solder.

According to another embodiment of the present disclosure, the thin film solar cell layer may be configured of a CIGS, Perovskite or CIGS-Perovskite tandem thin film solar cell layer.

According to another embodiment of the present disclosure, the second stage may further include disposing a back glass substrate on a back surface of the thin film solar cell.

According to another embodiment of the present disclosure, the second stage may further include bonding the thin film solar cell and the upper glass substrate by applying a sealing material between the thin film solar cell and the upper glass substrate.

According to another embodiment of the present disclosure, the second stage may further include bonding the thin film solar cell, the upper glass substrate and the back glass substrate by applying a sealing material between the thin film solar cell and the upper glass substrate and between the thin film solar cell and the back glass substrate.

According to another embodiment of the present disclosure, the sealing material may be configured of polyolefin elastomer (POE) or ethylene vinyl acetate (EVA).

A transparent solar cell module according to an embodiment of the present disclosure includes: a thin film solar cell including a glass substrate and a thin film solar cell layer patterned on the glass substrate; and an upper glass substrate disposed on an upper surface of the thin film solar cell, wherein the thin film solar cell layer is formed by processing by irradiating a laser on a pattern mask formed on the other surface of a surface on which the thin film solar cell layer of the glass substrate is formed.

According to another embodiment of the present disclosure, the thin film solar cell layer may be formed to include an electrode (busbar) by irradiating a laser on the pattern mask formed on the other surface of the surface on which the thin film solar cell layer of the glass substrate is formed.

According to another embodiment of the present disclosure, the thin film solar cell layer may be formed with a processing line width of 0.05 mm to 5 mm by irradiating the pattern mask formed on the other surface of the surface on which the thin film solar cell layer of the glass substrate is formed with an overlap rate of laser beams of 50% or more.

According to another embodiment of the present disclosure, the thin film solar cell layer may further include a terminal made of copper or aluminum material connected to the electrode (busbar) by a conductive tape, ultrasonic welding, or solder.

According to another embodiment of the present disclosure, the thin film solar cell layer may be configured of a CIGS, Perovskite or CIGS-Perovskite tandem thin film solar cell layer.

According to another embodiment of the present disclosure, there may be further included a back glass substrate disposed on a back surface of the thin film solar cell.

According to another embodiment of the present disclosure, there may be further included a sealing material applied between the thin film solar cell and the upper glass substrate to bond the thin film solar cell and the upper glass substrate.

According to another embodiment of the present disclosure, there may be further included a sealing material disposed between the thin film solar cell and the upper glass substrate and between the thin film solar cell and the back glass substrate to bond the thin film solar cell, the upper glass substrate and the back glass substrate.

According to another embodiment of the present disclosure, the sealing material may be configured of polyolefin elastomer (POE) or ethylene vinyl acetate (EVA).

An embodiment of the present disclosure can provide a transparent solar cell module with excellent aesthetics that minimizes dead lines that may occur during pattern formation, maximizes energy conversion efficiency by utilizing the solar cell layer as is, and allows appropriate light to pass through, and a manufacturing method thereof.

More specifically, an embodiment of the present disclosure is designed to alleviate the output reduction caused by shading of products that provide aesthetics by adding patterns and designs to the front glass of solar cell modules in existing technologies, and to maximize energy conversion efficiency as well as visibility and aesthetics by enabling design through processing of the thin film itself.

### BRIEF DESCRIPTION OF THE DRAWING

FIG. 1 is a diagram illustrating a transparent solar cell module according to an embodiment of the present disclosure.
FIG. 2 is an exploded perspective view of a transparent solar cell module according to an embodiment of the present disclosure.
FIG. 3 is an exploded perspective view of a transparent solar cell module according to another embodiment of the present disclosure.
FIG. 4 is a flowchart illustrating a method of manufacturing a transparent solar cell module according to an embodiment of the present disclosure.
FIG. 5 is a diagram illustrating a method of manufacturing a transparent solar cell module according to an embodiment of the present disclosure.
FIG. 6 is a diagram illustrating an actual transparent solar cell module manufactured according to an embodiment of the present disclosure.

### DETAILED DESCRIPTION

The present disclosure may be modified in various forms and embodied in a variety of different embodiments, and specific embodiments thereof will be illustrated in the drawings and described in detail in the detailed description. However, this is not intended to limit the present disclosure to specific embodiments, and it should be understood that all modifications, equivalents and substitutes included in the spirit and technical scope of the present disclosure are included.

In addition, in the following description, when it is determined that the specific descriptions of well-known functions or configurations unnecessarily obscure the gist of the present disclosure, the detailed description therefor may be omitted. In addition, sizes of components in the drawings may be exaggerated for convenience of explanation, and the sizes of components do not utterly reflect an actual size.

In addition, it will be understood that, throughout the specification, when a component is referred to as being "connected to" or "coupled to" another component, the component may be directly connected or directly coupled to the other component, but, unless explicitly described to the contrary, the component may be connected or coupled to the other component or intervening components may be present. In addition, throughout the specification, when a certain portion "comprises or includes" a certain component, this indicates that the other components are not excluded and may be further included unless specially described otherwise.

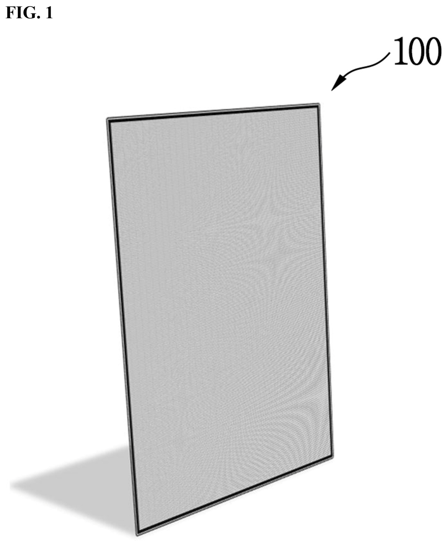

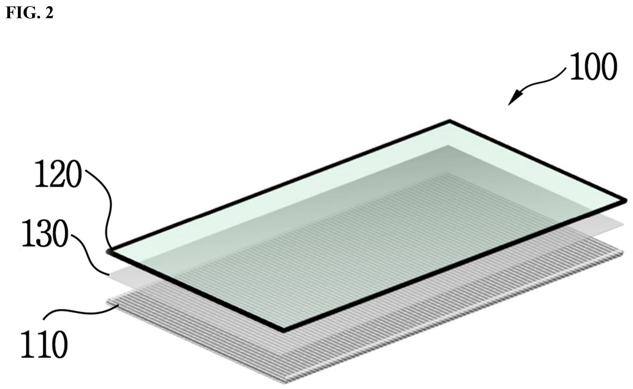

FIG. 1 is a diagram illustrating a transparent solar cell module according to an embodiment of the present disclosure. FIG. 2 is an exploded perspective view of a transparent solar cell module according to an embodiment of the present disclosure.

Hereinafter, with reference to the drawings, FIG. 2 will explain the configuration of a transparent solar cell module according to an embodiment of the present disclosure.

A transparent solar cell module 100 according to an embodiment of the present disclosure includes a thin film solar cell 110 and an upper glass substrate 120.

The thin film solar cell 110 includes a glass substrate and a thin film solar cell layer patterned on the glass substrate.

The thin film solar cell layer may be formed by processing by irradiating a laser on a pattern mask formed on the glass substrate.

In this connection, the pattern mask may be formed on the other surface of a surface on which the thin film solar cell layer is formed on the glass substrate, and may be formed to include an electrode (busbar) by irradiating a laser on the other surface of the pattern mask.

The pattern mask is configured of a metal tape or a material that has not been processed by a laser. In this connection, the pattern mask is designed to adhere as closely as possible to the glass substrate to prevent processing errors due to floating up.

Furthermore, the thin film solar cell 110 is designed to have the pattern mask formed on an electrode portion at both ends. This ensures that the electrode portion is processed together during laser processing, thereby narrowing an area of the electrode during subsequent module manufacturing, which not only generates resistance but also prevents output reduction due to a decrease in the filling rate and current when each formed module does not make smooth contact with the electrode (busbar).

As such, the thin film solar cell layer may be formed with a processing line width of 0.05 mm to 5 mm by irradiating the pattern mask formed on the other surface of the surface on which the thin film solar cell layer of the glass substrate is formed with an overlap rate of laser beams of 50% or more.

In addition, the thin film solar cell layer may further include a terminal made of copper or aluminum material connected to the electrode (busbar) by a conductive tape, ultrasonic welding, or solder.

In addition, the thin film solar cell layer according to an embodiment of the present disclosure may be configured of a CIGS, Perovskite or CIGS-Perovskite tandem thin film solar cell layer.

The CIGS is a semiconductor material used in thin-film solar cells, and has high efficiency and is applicable to flexible substrates, enabling the manufacture of various types of solar cells. CIGS thin-film solar cells are characterized by stability even in high-temperature environments.

The perovskite is a solar cell material that has recently attracted significant attention, and offers the advantage of high efficiency at low cost.

Tandem solar cells, which combine CIGS and perovskite, leverage the strengths of both materials to absorb a wider range of light and maximize efficiency. Generally, the CIGS absorbs well in the infrared region of sunlight, while the perovskite absorbs well in the visible and ultraviolet regions. A combination thereof offers the advantage of further enhancing energy conversion efficiency.

The transparent solar cell module 100 according to an embodiment of the present disclosure may further include a sealing material 130.

The sealing material 130 is applied between the thin film solar cell 110 and the upper glass substrate 120 to bond the thin film solar cell 110 and the upper glass substrate 120.

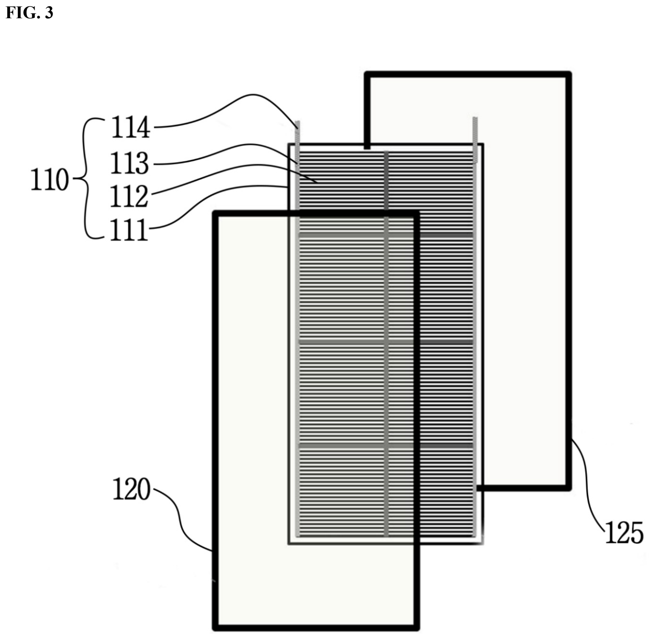

FIG. 3 is an exploded perspective view of a transparent solar cell module according to another embodiment of the present disclosure.

A transparent solar cell module according to another embodiment of the present disclosure may include the thin film solar cell 110, the upper glass substrate 120, and the back glass substrate 125.

The thin film solar cell 110 includes a glass substrate 111 and a thin film solar cell layer 112 patterned on the glass substrate 111.

The thin film solar cell layer 112 may be formed by processing by irradiating a laser on a pattern mask formed on the glass substrate 111.

In this connection, the pattern mask may be formed on the other surface of a surface on which the thin film solar cell layer 112 is formed on the glass substrate 111, and may be formed to include an electrode (busbar) 113 by irradiating a laser on the other surface of the pattern mask.

The pattern mask is configured of a metal tape or a material that has not been processed by a laser. In this connection, the pattern mask is designed to adhere as closely as possible to the glass substrate 111 to prevent processing errors due to floating up.

Furthermore, the thin film solar cell 110 is designed to have the pattern mask formed on an electrode 113 portions at both ends. This ensures that the electrode portion is processed together during laser processing, thereby narrowing an area of the electrode during subsequent module manufacturing, which not only generates resistance but also prevents output reduction due to a decrease in the filling rate and current when each formed module does not make smooth contact with the electrode (busbar).

As such, the thin film solar cell layer 112 may be formed with a processing line width of 0.05 mm to 5 mm by irradiating the pattern mask formed on the other surface of the surface on which the thin film solar cell layer 112 of the glass substrate 111 is formed with an overlap rate of laser beams of 50% or more.

In addition, the thin film solar cell layer 112 may further include a terminal 114 made of copper or aluminum material connected to the electrode (busbar) 113 by a conductive tape, ultrasonic welding, or solder.

As described above, the thin film solar cell layer 112 according to an embodiment of the present disclosure may be configured of a CIGS, Perovskite or CIGS-Perovskite tandem thin film solar cell layer.

In addition, the transparent solar cell module 100 according to another embodiment of the present disclosure may further include the sealing material 130.

The sealing material 130 may be disposed between the thin film solar cell 110 and the upper glass substrate 120 and between the thin film solar cell 110 and the back glass substrate 125 to bond the thin film solar cell 110, the upper glass substrate 120 and the back glass substrate 125.

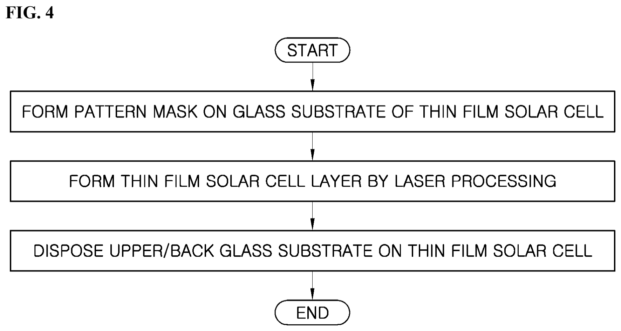

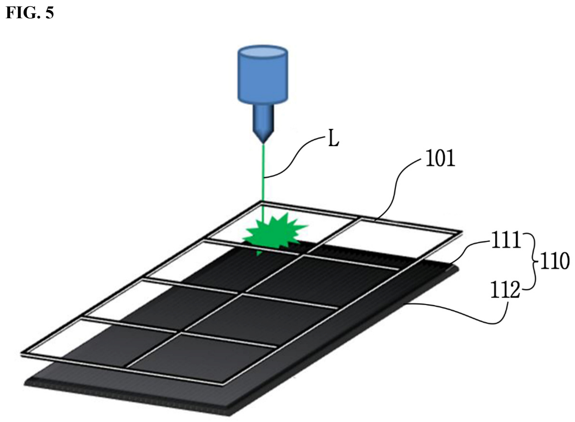

FIG. 4 is a flowchart illustrating a method of manufacturing a transparent solar cell module according to an embodiment of the present disclosure. FIG. 5 is a diagram illustrating a method of manufacturing a transparent solar cell module according to an embodiment of the present disclosure.

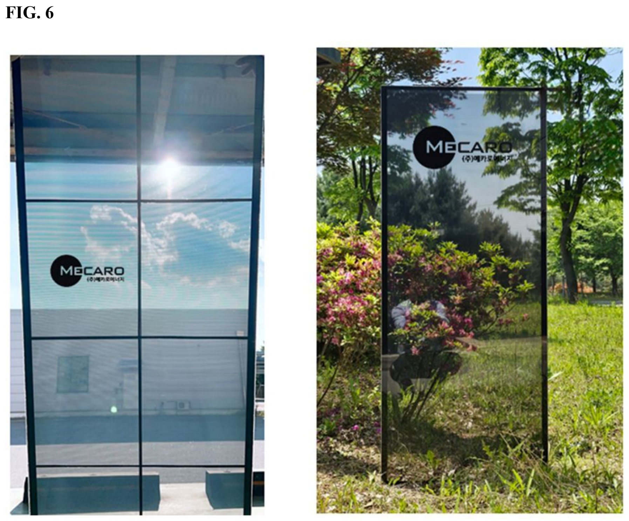

In addition, FIG. 6 is a diagram illustrating an actual transparent solar cell module manufactured according to an embodiment of the present disclosure.

Hereinafter, with reference to FIGS. 4 to 6, a method of manufacturing a transparent solar cell module according to an embodiment of the present disclosure will be described.

First, a pattern mask 101 is formed on the glass substrate 111 (S210).

In this connection, the pattern mask 101 is formed on the other surface of a surface on which the thin film solar cell layer 112 is formed on the glass substrate 111.

In this connection, the pattern mask 101 may be formed on the other surface of a surface on which the thin film solar cell layer is formed on the glass substrate 111, and the pattern mask 101 is configured of a metal tape or a material that has not been processed by a laser. In this connection, the pattern mask 101 is designed to adhere as closely as possible to the glass substrate 111 to prevent processing errors due to floating up.

In addition, the thin film solar cell 110 is designed to have the pattern mask 101 formed on an electrode portion at both ends.

Thereafter, the thin film solar cell layer 112 is formed by processing by irradiating a laser L on an upper portion where the pattern mask 101 is formed (S220).

In this connection, the thin film solar cell layer 112 including the electrode (busbar) may be formed by irradiating a laser L on the pattern mask 101 formed on the other surface of the surface on which the thin film solar cell layer 112 of the glass substrate 111 is formed.

As such, the thin film solar cell 110 is designed to have the pattern mask 101 formed on an electrode portion at both ends. This ensures that the electrode portion is processed together during laser processing, thereby narrowing an area of the electrode during subsequent module manufacturing, which not only generates resistance but also prevents output reduction due to a decrease in the filling rate and current when each formed module does not make smooth contact with the electrode (busbar).

In addition, a terminal made of copper or aluminum material connected to the electrode (busbar) may be formed by a conductive tape, ultrasonic welding, or solder.

More specifically, the thin film solar cell layer 112 may be formed with a processing line width of 0.05 mm to 5 mm by irradiating the pattern mask 101 formed on the other surface of the surface on which the thin film solar cell layer 112 of the glass substrate 111 is formed with an overlap rate of laser beams L of 50% or more.

The thin film solar cell layer 112 formed as such may be configured of a CIGS, Perovskite or CIGS-Perovskite tandem thin film solar cell layer.

Thereafter, the upper glass substrate is disposed on an upper surface of the thin film solar cell 110. In addition, the back glass substrate may be disposed on a back surface of the thin film solar cell 110.

In this connection, a sealing material may be applied between the thin film solar cell 110 and the upper glass substrate to bond the thin film solar cell 110 and the upper glass substrate. In addition, a sealing material may be applied between the thin film solar cell 110 and the upper glass substrate and between the thin film solar cell 110 and the back glass substrate to bond the thin film solar cell 110, the upper glass substrate and the back glass substrate.

In addition, the sealing material is configured of polyolefin elastomer (POE) or ethylene vinyl acetate (EVA).

As such, an embodiment of the present disclosure is directed to providing a transparent solar cell module with excellent aesthetics that minimizes dead lines that may occur during pattern formation, maximizes energy conversion efficiency by utilizing the solar cell layer as is, and allows appropriate light to pass through, and a manufacturing method thereof.

More specifically, an embodiment of the present disclosure is designed to alleviate the output reduction caused by shading of products that provide aesthetics by adding patterns and designs to the front glass of solar cell modules in existing technologies, and to maximize energy conversion efficiency as well as visibility and aesthetics by enabling design through processing of the thin film itself.

As described above, the detailed description of the present disclosure has described specific embodiments. However, various modifications are possible without departing from the scope of the present disclosure. The technical spirit of the present disclosure should not be limited to the aforementioned embodiments, but should be defined not only by the claims but also by equivalents thereof.

### Description of Reference Numerals

100: transparent solar cell module
101: pattern mask
110: thin film solar cell
111: glass substrate
112: thin film solar cell layer
113: electrode
114: terminal
120: upper glass substrate
125: back glass substrate
130: sealing material

## Claims

1. A method of manufacturing a transparent solar cell module, the method comprising:
a first stage of forming a thin film solar cell comprising a thin film solar cell layer patterned on a glass substrate; and
a second stage in which an upper glass substrate is disposed on an upper surface of the thin film solar cell,
wherein the first stage comprises:
forming a pattern mask on the other surface of a surface on which the thin film solar cell layer of the glass substrate is formed; and
forming the thin film solar cell layer by processing by irradiating a laser on an upper portion where the pattern mask is formed.

2. The method of claim 1, wherein the formation of the thin film solar cell layer is configured to form the thin film solar cell layer comprising an electrode (busbar) by irradiating a laser on the pattern mask formed on the other surface of the surface on which the thin film solar cell layer of the glass substrate is formed.

3. The method of claim 2, wherein after the formation of the thin film solar cell layer, the method further comprises forming a terminal made of copper or aluminum material connected to the electrode (busbar) by a conductive tape, ultrasonic welding, or solder.

4. The method of claim 1, wherein the thin film solar cell layer is configured of a CIGS, Perovskite or CIGS-Perovskite tandem thin film solar cell layer.

5. The method of claim 1, wherein the second stage further comprises disposing a back glass substrate on a back surface of the thin film solar cell.

6. The method of claim 1, wherein the second stage further comprises bonding the thin film solar cell and the upper glass substrate by applying a sealing material between the thin film solar cell and the upper glass substrate.

7. The method of claim 5, wherein the second stage further comprises bonding the thin film solar cell, the upper glass substrate and the back glass substrate by applying a sealing material between the thin film solar cell and the upper glass substrate and between the thin film solar cell and the back glass substrate.

8. The method of claim 6 or 7, wherein the sealing material is configured of polyolefin elastomer (POE) or ethylene vinyl acetate (EVA).

9. A transparent solar cell module comprising:
a thin film solar cell comprising a glass substrate and a thin film solar cell layer patterned on the glass substrate; and
an upper glass substrate disposed on an upper surface of the thin film solar cell,
wherein the thin film solar cell layer is formed by processing by irradiating a laser on a pattern mask formed on the other surface of a surface on which the thin film solar cell layer of the glass substrate is formed.

10. The transparent solar cell module of claim 10, wherein the thin film solar cell layer is formed to comprise an electrode (busbar) by irradiating a laser on the pattern mask formed on the other surface of the surface on which the thin film solar cell layer of the glass substrate is formed.

11. The transparent solar cell module of claim 10, wherein the thin film solar cell layer further comprises a terminal made of copper or aluminum material connected to the electrode (busbar) by a conductive tape, ultrasonic welding, or solder.

12. The transparent solar cell module of claim 9, wherein the thin film solar cell layer is configured of a CIGS, Perovskite or CIGS-Perovskite tandem thin film solar cell layer.

13. The transparent solar cell module of claim 9, further comprising a back glass substrate disposed on a back surface of the thin film solar cell.

14. The transparent solar cell module of claim 9, further comprising a sealing material applied between the thin film solar cell and the upper glass substrate to bond the thin film solar cell and the upper glass substrate.

15. The transparent solar cell module of claim 13, further comprising a sealing material disposed between the thin film solar cell and the upper glass substrate and between the thin film solar cell and the back glass substrate to bond the thin film solar cell, the upper glass substrate and the back glass substrate, the sealing material preferably being configured of polyolefin elastomer (POE) or ethylene vinyl acetate (EVA).
